**Europäisches Patentamt**

(19) **European Patent Office**

**Office européen des brevets**

(11) Publication number : **0 357 159 B1**

(12) # EUROPEAN PATENT SPECIFICATION

(45) Date of publication of patent specification :
20.05.92 Bulletin 92/21

(51) Int. Cl.⁵ : **C08F 2/42,** C08F 6/02,
C08F 10/02

(21) Application number : **89202636.0**

(22) Date of filing : **30.09.85**

(54) **Method of deactivating ethylene polymerization catalysts.**

(30) Priority : **09.01.85 US 689953**

(43) Date of publication of application :
**07.03.90 Bulletin 90/10**

(60) Publication number of the earlier application in accordance with Art. 76 EPC : **0 191 220**

(45) Publication of the grant of the patent :
**20.05.92 Bulletin 92/21**

(84) Designated Contracting States :
**BE DE FR GB IT NL**

(56) References cited :
**CH-A- 435 739**

(73) Proprietor : **QUANTUM CHEMICAL CORPORATION**
**11500 Northlake Drive**
**Cincinnati, OH 45249 (US)**

(72) Inventor : **Hwang, Yu-Tang**
**1109 Moorland Avenue**
**Shorewood, Illinois 60435 (US)**
Inventor : **Pebsworth, Lloyd W.**
**304 Briar Lane**
**Morris, Illinois 60450 (US)**
Inventor : **Dombro, Robert A.**
**3013 Winterwood Drive**
**Springfield, Illinois 62704 (US)**
Inventor : **Hoff, Raymond E.**
**244 South Oak**
**Palatine Illinois 60067 (US)**

(74) Representative : **Spencer, Graham Easdale et al**
**A.A. Thornton & CO Northumberland House**
**303-306, High Holborn**
**London WC1V 7LE (GB)**

## Description

This invention is concerned generally with a method of terminating ethylene polymerization and copolymerization processes and, more specifically, with the deactivation of Ziegler catalysts used in such polymerization processes.

In polyethylene production generally, and particularly in the production of high density polyethylene (HDPE) or linear low density polyethylene copolymers (LLDPE) in high pressure reactors, it is necessary to terminate the polymerization reaction at a particular point in order to prevent the production of undesirable products, such as waxes, and low molecular weight materials, such as oligomers.

Typically in such processes, a catalyst comprising a transition metal compound, conventionally referred to as a "Ziegler catalyst", in association with an organometallic cocatalyst, is contacted with ethylene or ethylene and one or more 1-olefin or diolefin comonomers having at least three carbon atoms, under conditions of moderate to high pressure and high temperature. Under such conditions, ethylene is a liquid and acts as a solvent for the product polymer.

Typically, the product is discharged from the reactor in the form of a stream of polymer solution into one or more relatively low pressure separators where unpolymerized monomer and comonomer are removed from the polymer solution by evaporation.

The stream of polymer solution is actively polymerizing as it leaves the reactor since catalyst components are still present in the stream. It is therefore necessary to terminate the polymerization reaction by deactivating the catalyst components in order to avoid the production of undesirable byproducts.

A known means of terminating ethylene polymerization reactions is described in U.S.-A-4105609. This patent describes the use of an alkali metal salt or alkaline earth metal salt of a carboxylic acid, such as calcium stearate, as a deactivating agent for a Ziegler catalyst.

Other prior art deactivation methods use such deactivating agents as humidified calcium stearate, salts of alkali metals, inorganic polybasic acids and water, or water combined with an alkaline earth metal or zinc salt of an aliphatic monocarboxylic acid containing from 6 to 22 carbon atoms. Still other known deactivating agents include aqueous non-ionic surfactants and flux-calcined diatomite.

However, none of these prior art methods of catalyst deactivation have been completely satisfactory in terminating ethylene polymerization and copolymerization processes.

We have now found that alkali metal and alkaline earth metal salts of certain organic sulfonic and sulfuric acids are effective deactivators for such ethylene polymerization catalysts.

According to the present invention there is provided a method of homopolymerizing ethylene or interpolymerizing ethylene with one or more 1-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is an alkali metal or alkaline earth metal salt of an alkarylsulfonic acid or an alkyl or alkaryl sulfuric acid.

The deactivating agent and the products of reaction between the agent and the components of the catalyst remain in the polymer solution and act as halogen scavengers, thereby providing a corrosion inhibiting effect in the process equipment.

The catalyst is quickly and effectively deactivated by the method of the invention, thereby preventing complications such as the formation of waxes and oligomers.

The method of the invention is suitable for polymerizing or copolymerizing, in batch or continuous processes, ethylene or ethylene and one or more 1-olefins or diolefins having at least three carbon atoms, under various conditions of pressure and temperature. The method of the invention is particularly suitable for polymerization processes using medium to high pressures and high temperatures. The preferred temperature range is from 130°C to 300°C with pressures preferably in the range of from 69 MPa-172 MPa (10,000 to 25,000 psig). Polymerization processes of this type are described in U.S.-A-4105609.

The polymerization reaction may be carried out in a reactor of any convenient type, including, for example, stirred autoclave reactors and tubular reactors, or in a series of reactors of either the autoclave or tubular type. The polymerization conditions are preferably selected such that the reaction mixture of monomer, comonomer (if present), and polymer is homogeneous, i.e. the polymer is soluble in the reaction mixture.

If desired, chain transfer agents, such as hydrogen, or liquid diluents, such as liquid alkanes, can be present in the reaction mixture.

As is well known in the art, when polymerization is effected to form a solution of the product polymer in liquefied monomer(s), the polymer solution can be discharged as a stream from the reactor into a separator or series of separators which operate at low pressures relative to that of the reactor, in which the polymer is obtained from the polymer solution by degassing, that is vaporisation of the unreacted monomer and com-

EP 0 357 159 B1

onomer, which are then recycled to the reactor.

The stream of polymer solution which is discharged from the reactor still contains catalyst components. The present invention broadly contemplates the use of catalysts comprising a transition metal compound, conventionally referred to as "Ziegler catalysts", in association with an organometallic cocatalyst, such as an alkyl aluminium compound.

Such two component catalysts are well known in the art and the use of such catalysts is not critical to the practice of the invention. In general, such catalysts contain a transition metal, preferably titanium and/or vanadium, together with a Group IIA metal compound, such as an organomagnesium compound, or an organoaluminium compound.

In a preferred embodiment of the invention, the deactivator is added directly to the actively polymerizing stream of polymer solution, for example by injection, prior to degassing of the polymer solution. The deactivator may be introduced into the polymer stream in dry form, in admixture with water, or as a solution or suspension in an inert liquid diluent, such as mineral spirits. Preferably, the deactivator is added in a slurry form in an inert liquid diluent.

The amount of deactivator added to the polymerization mixture must, of course, be sufficient to ensure deactivation of the catalyst and termination of polymerization. Deactivation is effected by the destruction of at least one of the constituents of the catalyst, that is the transition metal derivative and/or the organometallic cocatalyst. It is preferred to use sufficient deactivator to react with all of the metallic components of the catalyst. Preferably from 0.1 to 10 moles of deactivator are used for each mole of metal in the catalyst.

Deactivation of a Ziegler catalyst in an actively polymerizing mixture by the method of the invention results in rapid, effective deactivation of the polymerization reaction, thereby preventing the formation of undesirable by-products, such as waxes, and low molecular weight products, such as oligomers. The deactivating agent reacts with the metallic components of the Ziegler catalyst system and the reaction products and any unreacted deactivating agent remain in the polymer after monomer removal.

An important benefit of the invention is the halogen scavenging ability of the deactivators, which significantly inhibits corrosion of process equipment when the deactivator and its reaction products with the components of the catalyst system remain in the polymer. For example, chloride in the catalyst is effectively neutralised by the method according to the invention. The invention also provides ready control of the composition of the gases recycled to the reactor from the low pressure separators, thereby allowing ready control of the relative amounts of the constituents in the reactor.

The salts which are used as deactivators in accordance with the invention are of the formula $(RC_6H_4SO_3)_cM$ (the sulfonic acid salts) or $(ROSO_3)_cM$ (the sulfuric acid salts), where M is an alkali metal or alkaline earth metal, c is the valency of M, and R is a hydrocarbon group containing from 1 to 22 carbon atoms. Preferred examples of these salts are sodium and calcium dodecylbenzene sulphonates, sodium dodecyl sulphate and sodium lauryl sulphate.

In order that the invention may be more fully understood, the following examples are given by way of illustration.

<u>Examples</u>

A series of ethylene/1-butene copolymerization reactions were carried out in a one-litre autoclave reactor equipped with a catalyst injector and a separate deactivator injector. Isopar H (supplied by Exxon) was used as a diluent. An alkyl aluminium cocatalyst, liquid ethylene at 3.45 MPa (500 psig), and 15% by weight of 1-butene were placed in the reactor at 220°C and a titanium/magnesium catalyst was injected under nitrogen pressure. The rate of reaction was monitored and when maximum reactivity was achieved, the deactivator compound was injected under nitrogen pressure. The effectiveness of each deactivator was measured in terms of the number of seconds required after the deactivator had been injected into the active polymerization zone for the ethylene flow to fall to less than 5% compared with a blank test in which no deactivator was injected. The compound injected was considered to be an effective deactivator if it reduced the ethylene flow to less than 5% within 30 seconds of its injection into the polymerization mixture.

The following Table shows the results obtained:

TABLE

| Example | Deactivator | Mole Ratio Deactivator to Catalyst[b] | Ethylene Flow at Time of Deactivator Injection, % | Maximum Ethylene Flow Reached, % | Time to Deactivate Seconds[c] |
|---|---|---|---|---|---|
| 1 | None[a] | – | – | 55 | 120 |
| 2 | Sodium do-decylbenzene Sulfonate[d] | 0.25 | 62 | 83 | 50 |
| 3 | " | 0.5 | 46 | 46 | 28 |
| 4 | " | 1.0 | 39 | 49 | 24 |
| 5 | Calcium do-decylbenzene Sulfonate[e] | 0.125 | 51 | 51 | no effect |
| 6 | " | 0.25 | 44 | 44 | 20 |
| 7 | " | 0.5 | 51 | 51 | 26 |
| 8 | Sodium lauryl sulphate[f] | 0.5 | n/a | n/a | 22 |
| 9 | " | 1.0 | 52 | 70 | 28 |

Footnotes to Table

a) Blank test.
b) The catalyst contains compounds of titanium, magnesium and aluminium.
c) Time required to fall to 5% ethylene flow following injection of deactivator compound.
d) Siponate DS-10 from Alcolac, Inc.; 10 wt.% in Isopar H.
e) Ninate 401 from Stepan Chemical Co.; 10 wt.% in Isopar H.
f) Stepan Chemical Co. product in Isopar H.

## Claims

1. A method of homopolymerizing ethylene or interpolymerizing ethylene with one or more 1-olefins or diolefins having at least three carbon atoms by subjecting the monomer(s) to polymerizing conditions in a reactor in the presence of a catalyst which comprises a transition metal derivative, and terminating the polymerization by adding a sufficient amount of a catalyst deactivator to the polymerization mixture or a part thereof, characterised in that the deactivator is an alkali metal or alkaline earth metal salt of an alkarylsulfonic acid or an alkyl or alkaryl sulfuric acid.

2. A method according to claim 1, in which the polymerization mixture consists of a solution of the polymer obtained in liquefied, unpolymerized, monomer(s), a portion of the polymerization mixture is removed from the reactor, the deactivator is added thereto, and the unpolymerized monomer(s) is/are removed by evaporation.

3. A method according to claim 1 or 2, in which up to 10 moles of the deactivator are added per mole of metal in the catalyst.

4. A method according to any of claims 1 to 3, in which the deactivator is a salt of the formula $(RC_6H_4SO_3)_cM$ or $(ROSO_3)_cM$, where M is an alkali metal or alkaline earth metal, c is the valency of M, and R is a hydrocarbon group having from 1 to 22 carbon atoms.

5. A method according to claim 4, in which the deactivator is sodium or calcium dodecylbenzene sulfonate, sodium dodecyl sulfate or sodium lauryl sulfate.

## Patentansprüche

1. Verfahren zur Homopolymerisation von Ethylen oder Mischpolymerisation von Ethylen mit einem oder mehreren 1-Olefinen oder Diolefinen mit wenigstens 3 Kohlenstoffatomen durch Behandeln des oder der Monomeren in einem Reaktor unter Polymerisations-bedingungen in Gegenwart eines ein Übergangsmetall-Derivat enthaltenden Katalysators und Abbrechen der Polymerisation durch Zugabe einer hinreichenden Menge eines Desaktivators für den Katalysator zu der Polymerisationsmischung oder einem Teil davon, dadurch **gekennzeichnet**, daß der Desaktivator das Alkalimetall- oder Erdalkalimetallsalz von einer Alkarysulfonsäure oder einer Alkyl- oder Alkyarylschwefelsäure ist.

2. Verfahren gemäß Anspruch 1, wobei die Polymerisationsmischung aus der Lösung des erhaltenen Polymeren in dem oder den verflüssigten Monomeren besteht, ein Teil der Polymerisationsmischung dem Reaktor entnommen wird, der Desaktivator dazu beigefügt wird und das oder die unpolymerisierten Monomeren durch Verdampfung entfernt werden.

3. Verfahren gemäß Anspruch 1 oder 2, wobei bis zu 10 Mol des Desaktivators je Mol des im Katalysator enthaltenen Metalls zugegeben werden.

4. Verfahren nach einem der Ansprüche 1 bis 3, wobei der Desaktivator ein Salz mit der Formel $(RC_6H_4SO_3)_cM$ oder $(ROSO_3)_cM$ ist, worin M ein Alkalimetall oder ein Erdalkalimetall ist, c der Wertigkeit von M entspricht und R eine Kohlenwasserstoffgruppe mit 1 bis 22 Kohlenstoffatomen darstellt.

5. Verfahren gemäß Anspruch 4, wobei der Desaktivator Natriumoder Calciumdodecylbenzolsulfonat, Natriumdodecylsulfat oder Natriumlaurylsulfat ist.

## Revendications

1. Une méthode d'homopolymérisation de l'éthylène ou d'interpolymérisation de l'éthylène avec une ou plusieurs 1-oléfines ou dioléfines ayant au moins trois atomes de carbone en soumettant le ou les monomères à des conditions de polymérisation dans un réacteur en présence d'un catalyseur qui comprend un dérivé de métal de transition, et en terminant la polymérisation par addition d'une quantité suffisante d'un désactivant de catalyseur au mélange de polymérisation ou à une partie de ce mélange, caractérisée en ce que le désactivant est un sel de métal alcalin ou un sel de métal alcalino-terreux d'un acide alcarylsulfonique ou d'un acide alkyl- ou alcarylsulfurique.

2. Une méthode selon la revendication 1, selon laquelle le mélange de polymérisation consiste en une solution de polymère obtenu dans le ou les monomère(s) liquéfié(s), non polymérisé(s), une portion du mélange de polymérisation est évacuée du réacteur, le désactivant y est ajouté, et le ou les monomère(s) non polymérisé(s) sont éliminés par évaporation.

3. La méthode selon la revendication 1 ou 2, selon laquelle jusqu'à 10 mol de désactivant sont ajoutés par mole de métal dans le catalyseur.

4. Une méthode selon l'une quelconque des revendications 1 à 3, selon laquelle le désactivant est un sel de formule $(RC_6H_4SO_3)_cM$ ou $(ROSO_3)_cM$, dans laquelle M est un métal alcalin ou un métal alcalino-terreux, c est la valence de M, et R est un groupe hydrocarboné ayant de 1 à 22 atomes de carbone.

5. Une méthode selon la revendication 4, selon laquelle le désactivant est le dodécylbenzènesulfonate de sodium ou de calcium, le dodécylsulfate de sodium ou le laurylsulfate de sodium.